Europäisches Patentamt

European Patent Office

Office européen des brevets

(11) Publication number: **0 510 198 A1**

## EUROPEAN PATENT APPLICATION
## published in accordance with Art. 158(3) EPC

(21) Application number: 91913101.1

(22) Date of filing: 24.07.91

(86) International application number: PCT/JP91/00988

(87) International publication number: WO 92/02046 (06.02.92 92/04)

(51) Int. Cl.⁵: H01L 27/115

(30) Priority: 24.07.90 JP 195858/90

(43) Date of publication of application: 28.10.92 Bulletin 92/44

(84) Designated Contracting States: DE FR GB IT NL

(71) Applicant: SEIKO EPSON CORPORATION 4-1, Nishishinjuku 2-chome Shinjuku-ku Tokyo 163(JP)

(72) Inventor: FUJISAWA, Akira 3-5, Owa 3-chome Suwa-shi, Nagano-ken 392(JP)

(74) Representative: Ouinterno, Giuseppe et al c/o Jacobacci-Casetta & Perani S.p.A. Via Alfieri, 17 I-10121 Torino(IT)

(54) METHOD OF MANUFACTURING SEMICONDUCTOR DEVICE.

(57) A method of manufacturing a semiconductor device including a process of forming a connection hole which connects either one of the electrodes so formed as to sandwich a ferroelectric layer between them with a diffusion layer having a high concentration of a semiconductor substrate, a process of forming a titanium thin film on the surface of the diffusion layer having a high concentration of the connection hole, a process of silicifying titanium by a heat treatment, a process of so removing unsilicified titanium as to leave silicified titanium, and a process of forming the electrodes for a capacitive element having a ferroelectric layer as its substrate.

FIG. 1

Technical Field

The present invention relates to a method of manufacturing a non-volatile semiconductor device having a semiconductor memory cell, more particularly an electrically polarizable ferroelectric layer as a basic material.

Background Art

A memory device based on an electrically polarizable layer has been developed since the beginning of the 1950's.

Information could be stored by giving a voltage to upper and lower corresponding electrodes (corresponding to lines and row numbers in case of a common semiconductor memory device), thereby polarizing an inter secting point region of these electrodes. Moreover, the read-out process can be carried out by piezoelectrically or pyroelectrically activating a special memory region or by destructively reading out. Furthermore, information can be kept permanently without supplying any other outside power supply source by residual polarizaton having a ferroelectric. However, it was found that a circumferential device, that is, an electron control device necessary for writing in and reading out information, is comparatively complicated and long access time is required. Therefore, at the end of the 1970's, there was proposed to directly integrate a ferromagnetic memory cell with a control module or to integrate the ferroelectric memory cell and the control module together. (R.C. Cook, US Patent 4149302 (1979)).

Recently, IEDM '87, pp. 850-851, proposes a memory device having a structure laminated in a MIS-type semiconductor device shown in Fig. 6. In Fig. 6, 701 is a P-type silicon substrate, 702 a LOCOS oxide film for separating elements, and 703 and 704 N-type diffusion layers as a source and a drain, respectively. 705 is a gate electrode, and 706 is an insulating film. 708 is a ferroelectric film and constructs a capacitor sandwiched by a lower electrode 707 and an upper electrode 709.

Problem to be solved by the Invention

The structure of laminating the upper portion of such MOS-type semiconductor device requires wiring for connecting the electrode of the ferroelectric to high concentration diffusion layers as source and drain on the semiconductor substrate, and has such a problem that an element area increases.

An object of the invention is to solve such problem, and to propose a method of manufacturing a semiconductor device having a capacitor element of extremely high quality ferroelectric properties and high integration with low cost by taking a square hysteresis curve and the like into consideration.

Disclosure of the Invention

A method of manufacturing a semiconductor device forming a capacitor element having a ferroelectric layer as a basic material according to the invention comprising the steps of

forming a connecting hole for connecting a high concentration diffusion layer of a semiconductor substrate to either one of electrodes formed by sandwiching said ferroelectric layer therebetween,

forming a titanium thin film on a surface of said high concentration diffusion layer of said connecting hole,

silicifying said titanium by a heat treatment,

removing non-silicified titanium for remaining said silicified titanium, and

forming an electrode of a capacitor element having said feroelectric layer as a basic material.

Brief Description of the Drawings

Fig. 1 is an essential cross section of a semiconductor device having an electrically polarizable ferroelectric layer as a basic material according to the present invention.

Figs. 2-5 are essential cross sections of manufacturing steps of a capacitor element of the semiconductor device having an electrically polarizable ferroelectric layer as a basic material according to the present invention.

Fig. 6 is a diagram showing one embodiment of a memory cell circuit of a ferroelectric memory according to the present invention.

Fig. 7 is an essential cross section of the prior semiconductor device having an electrically polarizable ferroelectric layer as a basic material.

Best Mode for carrying out the Invention

The invention will be explained by referring to the accompanying drawings and embodiments in detail.

Fig. 6 shows an embodiment of a memory cell circuit of a semiconductor memory device having an electrically polarizable ferroelectric layer as a basic material. 601 is a MOS transistor and 602 is a capacitor element as a ferroelectric layer according to the invention. 603 and 604 are a word line and a bit line, respectively. An actual structure and a manufacturing method of this memory cell will be explained here.

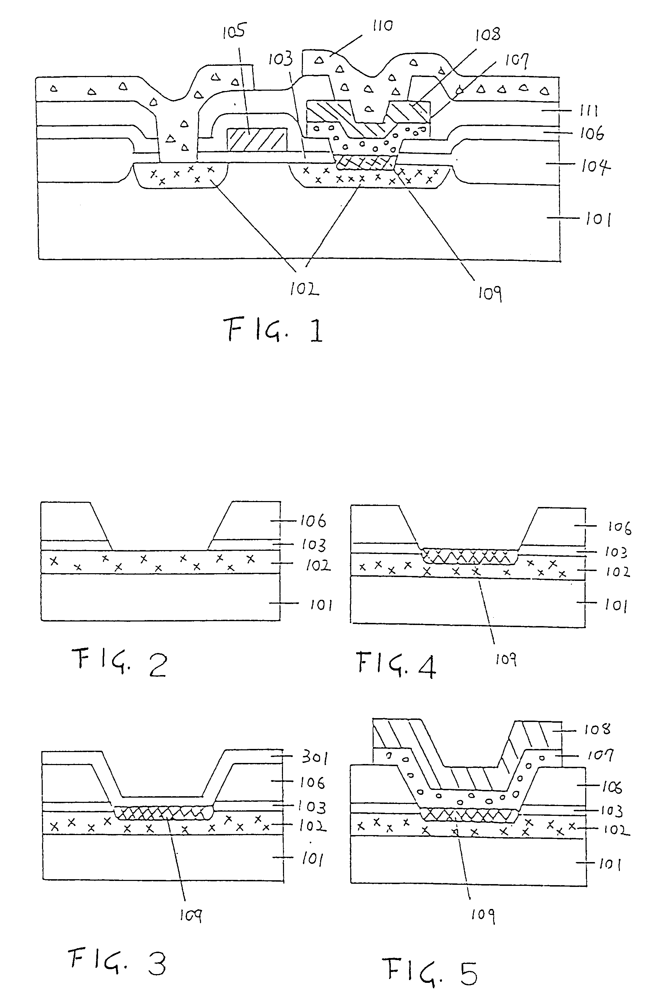

Fig. 1 shows an essential cross section of the memory cell circuit shown in Fig. 6. 101 is a P-type Si surface for instance. 102 is an N-type high concentration impurity diffusion layer formed by an ion injection method, for instance, to be a source and a drain of the MOS transistor. 103 is a gate oxide film of the MOS transistor and formed by thermal oxidation of a silicon substrate for instance. 104 is a LOCOS oxide film for separating the element. 105 is a gate electrode formed by N-type polysilicon for instance. 106 and 111 are insulating films forming SiO$_2$ with the use of a chemical gas phase growth method. 108 is a ferroelectric layer according to the invention.

A material of this ferroelectric layer is PbTiO$_3$, PZT or PLZT, and the ferroelectric layer is formed on one electrode (hereinafter referred to as "lower electrode") shown by 107 sandwiching a capacitor element by a sputtering method with the use of a target which lead component is suitably excessively compensated with respect to the stoichiometric composition. A material of the lower electrode 107 is platinum for instance, and the lower electrode is formed by sputtering.

101 is the other electrode (hereinafter referred to as "upper electrode") to the lower electrode of the capacitor element and formed by sputtering aluminum. In the present embodiment, an aluminum layer has a role as the upper electrode and simultaneously has a role as a bit line, but it is preferable to separate the aluminum layer into two and to form with different materials and layers as a matter of course.

With the structure shown in Fig. 1, the lower electrode of the capacitor element is directly formed on the high concentration diffusion layer via a silicified titanium thin film, so that a wiring area becomes small, and as a result, an element area becomes small and high integration becomes possible.

109 is a silicified titanium thin film formed by the manufacturing method according to the invention, and its preferable embodiment is explained following to the steps.

(a) First, as shown in Fig. 2, a connecting hole is provided in SiO$_2$ of the insulating film, 106 and the gate oxide film 103 on the high concentration diffusion layer 102 in the region forming the lower electrode of the capacitor element. This connecting hole is such as 5 $\mu$m in diameter, and the thickness of SiO$_2$ is 2000 Å. Such connecting hole is formed by patterning a resist by photolithographic technique and etching with an aqueous solution of hydrofluoric acid on the insulating film.

(b) Second, in Fig. 3, a titanium thin film 301 of 500 Å is formed on the substrate by sputtering. Then, a heat treatment is carried out at 800°C for 30 second by a rapid thermal annealing method. As a result, only the titanium thin film contacted with silicon of the high concentration diffusion layer of the connecting hole forms a silicified titanium 109.

(c) Third, when the substrate is treated in an aqueous solution containing a hydrogen peroxide solution and ammonia, the titatinum thin film 301 which is not silicified by said heat treatment is only selectively removed and the silicified titanium thin film 109 is only remained on the high concentration diffusion layer as shown in Fig. 4.

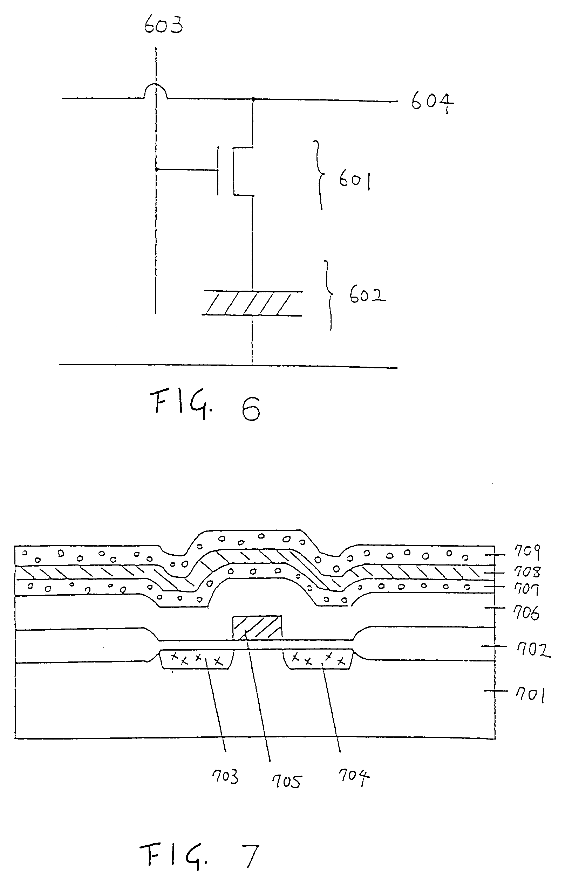

(d) Fourth, as shown in Fig. 5, the platinum 107 as the lower electrode is formed into 1000 Å by sputtering, and then the PST 108 as the ferroelectric layer is formed into 2000 Å by sputtering, and these two layers are simultaneously sputtered to form a capacitor element. The structure shown in Fig. 1 is finally formed.

In order to improve dielectric properties of a ferroelectric film, it is necessary to conduct a heat treatment in an atmosphere including oxygen after forming the ferroelectric thin film.

In Fig. 1, when there is no silicified titanium thin film 109, if the heat treatment is conducted in an atmosphere containing oxygen after forming the ferroelectric thin film, an oxide film is formed on the surface of the high concentration diffusion layer 102, and contact resistance between the lower electrode 107 and the high concentration diffusion layer 102 is increased. Moreover, even when silicified titanium is not removed as shown in Fig. 4, contact resistance between the lower electrode 107 and the high concentration diffusion layer 102 is increased. This is because silicification of titanium starts from the interface of titanium and the high concentration diffusion layer, does not fully diffuse silicon in the vicinity of the titanium surface, and remains non-reacted titanium. This non-reacted titanium is oxidized at the time of heat treatment in an atmosphere containing oxygen after forming the ferroelectric thin film.

Contrary to the above, when titanium silicide of 109 is formed between the lower electrode 107 and the high concentration diffusion layer 102, and non-reacted titanium is removed by selective etching, contact resistance is not increased even with the heat treatment in an atmosphere containing oxygen. Moreover, it is a known fact that sheet resistance of the high concentration diffusion layer is lowered about 1/10 by forming titanium silicide on the surface, and contributed to improvement of element efficiency.

Industrial Applicability

As stated above, according to the invention,

it becomes possible to apply a heat treatment of about 600°C to a ferroelectric layer for giving extremely excellent ferroelectric properties by taking switching rate, square hysteresis curve and the like into consideration, and it also becomes possible to manufacture a non-volatile semiconductor device having high integration.

**Claims**

1. A method of manufacturing a semiconductor device forming a capacitor element having a ferroelectric layer as a basic material comprising the steps of

   forming a connecting hole for connecting a high concentration diffusion layer of a semiconductor substrate to either one of electrodes formed by sandwiching said ferroelectric layer therebetween,

   forming a titanium thin film on a surface of said high concentration diffusion layer of said connecting hole,

   silicifying said titanium by a heat treatment,

   removing non-silicified titanium for remaining said silicified titanium, and

   forming an electrode of a capacitor element having the ferroelectric layer as a basic material.

FIG. 1

FIG. 2

FIG. 4

FIG. 3

FIG. 5

603

604

} 601

} 602

# FIG. 6

709

708

707

706

702

701

703    705    704

# FIG. 7

# INTERNATIONAL SEARCH REPORT

International Application No PCT/JP91/00988

## I. CLASSIFICATION OF SUBJECT MATTER (If several classification symbols apply, indicate all) [6]

According to International Patent Classification (IPC) or to both National Classification and IPC

Int. Cl$^5$  H01L27/115

## II. FIELDS SEARCHED

| Minimum Documentation Searched [7] | |
|---|---|
| Classification System | Classification Symbols |
| IPC | H01L27/115, 29/792, 29/46 |

| Documentation Searched other than Minimum Documentation to the Extent that such Documents are Included in the Fields Searched [8] |
|---|
| Jitsuyo Shinan Koho              1970 - 1990 |
| Kokai Jitsuyo Shinan Koho        1972 - 1990 |

## III. DOCUMENTS CONSIDERED TO BE RELEVANT [9]

| Category [*] | Citation of Document, [11] with indication, where appropriate, of the relevant passages [12] | Relevant to Claim No. [13] |
|---|---|---|
| Y | JP, A, 2-94559 (Toshiba Corp.), April 5, 1990 (05. 04. 90), Line 6, upper left column to line 6, lower left column, page 4 | 1 |
| Y | JP, A, 2-82639 (Mitsubishi Electric Corp.), March 23, 1990 (23. 03. 90), Line 14, upper right column to line 2, lower right column, page 3 | 1 |
| P | JP, A, 2-232973 (Seiko Epson Corp.), September 14, 1990 (14. 09. 90), Lines 7 to 17, lower right column, page 2 | 1 |
| Y | JP, A, 2-16770 (Fujitsu Ltd.), January 19, 1990 (19. 01. 90), Line 5, lower right column, page 2 to line 14, upper left column, page 3 | 1 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| October 21, 1991 (21. 10. 91) | October 28, 1991 (28. 10. 91) |

| International Searching Authority | Signature of Authorized Officer |
|---|---|
| Japanese Patent Office | |

Form PCT/ISA/210 (second sheet) (January 1985)